# EUROPEAN PATENT APPLICATION

(11) **EP 2 423 957 A1**
(43) Date of publication of application: **29.02.2012**
(21) Application number: 10174385.4
(22) Date of filing: 27.08.2010
(51) Int. Cl.: H01L 21/677

(54) **Pallet for accommodating thermal gradients arising during processing**

(71) Applicant: Applied Materials, Inc., Santa Clara, CA 95054 (US)
(72) Inventor: Flock, Annemarie, 63477, Maintal (DE); Schläfer, Susanne, 63654, Büdingen (DE); Sauer, Andreas, 63762, Großostheim (DE); Hoffmann, Josef, 63839, Kleinwallstadt (DE); Bergmann, Tobias, 63755, Alzenau (DE)
(74) Representative: Schley, Jan Malte

(57) **Abstract**

Pallets suited to accommodate thermal gradients during processing. In one aspect, a pallet includes a pair of elongate members, a fixed elongate lateral cross member fixedly coupled to each of the elongate members, and an elongate floating lateral cross member floatingly coupled to the elongate members. The floating lateral cross member displaced from the fixedly coupled lateral cross member to define a gap therebetween.

## Description

### BACKGROUND

This specification relates to relates to pallets for wafers and other substrates. The pallets are suited to accommodate thermal gradients that arise during processing.

Wafers and other substrates can be processed to fabricate a variety of different devices, including solar cells and microelectronic devices. The processing used to fabricate devices can at times require movement of substrates into processing devices that are kept at relatively high temperatures. For example, it may be necessary to introduce a substrate into a sputtering or evaporation device that is kept at temperatures of 100°C or more.

### SUMMARY

This disclosure describes pallets for wafers and other substrates. The pallets are suited to accommodate thermal gradients that arise during processing, including sputtering and evaporation.

In a first aspect, a device includes a generally planar substrate pallet. The pallet includes a pair of elongate members, a fixed elongate lateral cross member fixedly coupled to each of the elongate members, and an elongate floating lateral cross member floatingly coupled to the elongate members. The floating lateral cross member displaced from the fixedly coupled lateral cross member to define a gap therebetween.

In a second aspect, a device includes a generally planar substrate pallet having a front, a back, a pair of sides, a top, and a bottom. The substrate pallet includes a pair of side elongate members each disposed at a respective of the sides of the substrate pallet and an elongate lateral cross member fixedly coupled to each of the side elongate members at a pair of fixed couplings, the elongate lateral cross member disposed generally parallel to the front and the back of the substrate pallet.

In a third aspect, a method includes loading substrates onto a pallet comprising a first and second elongate members coupled together by a lateral cross member, transporting the pallet and substrates loaded thereon into a sputtering or evaporation deposition device, and depositing a metal film onto the substrates in the deposition device. The lateral cross member is fixedly coupled to the first elongate member and fixedly coupled to the second elongate member.

These and other aspects can include one or more of the following features. The elongate members can ach include one or more contact surfaces to be contacted by a handling or storage device. The elongate floating lateral cross member can be longitudinally deflectable relative to the elongate members. The elongate members can be generally parallel and each define a side of the substrate pallet. The pallet can include a substrate mounting frame dimensioned to span the gap between the fixed lateral cross member and the floating lateral cross member. The pallet can include a second substrate mounting frame dimensioned to span the gap between the fixed lateral cross member and the floating lateral cross member. A first coupling between the substrate mounting frame and the substrate pallet and a second coupling between the second substrate mounting frame and the substrate pallet can position the substrate mounting frame and the second substrate mounting frame adjacent one another but with a gap therebetween. The substrate mounting frame can define three or more openings dimensioned to expose portions of mounted wafer substrate to processing conditions. The device of claim 1, wherein the substrate mounting frame is dimensioned to span between the elongate members. The fixed lateral cross member can be fixedly coupled in a vicinity of the middle of the length of each of the elongate members. The elongate members and the fixed lateral cross member can all be 80 cm or more in length. The pallet can include a second elongate floating lateral cross member floatingly coupled to the elongate members, the second floating lateral cross member displaced from the fixedly coupled lateral cross member to define a second gap therebetween. The fixed lateral cross member can be positioned between the floating lateral cross member and the second floating lateral cross member. The pallet can include an elongate floating lateral cross member floatingly coupled to the side elongate members, the floating lateral cross member displaced from the fixedly coupled elongate lateral cross member to define a gap therebetween. The pallet can include a substrate mounting frame coupled to at least one of the side elongate members or to the elongate lateral cross member. The substrate mounting frame can be dimensioned to span the gap between the fixed lateral cross member and the floating lateral cross member. The pallet and substrates can be transported by contacting the elongate members with a transport device. The substrates can be loaded onto a substrate mounting frame having a first side coupled to at least one of the first elongate members, the second elongate member, or the fixedly coupled lateral cross member. A first side of the substrate mounting frame can be decoupled from the at least one of the first elongate members, the second elongate member, or the fixedly coupled lateral cross member. A second side of the substrate mounting frame can be coupled to the at least one of the first elongate members, the second elongate member, or the fixedly coupled lateral cross member.

The details of one or more implementations are set forth in the accompanying drawings and the description below. Other features and advantages will be apparent from the description and drawings, and from the claims.

### DESCRIPTION OF DRAWINGS

FIGS. 1-6 are schematic representations of example pallets that are adapted for use in processing systems where relatively large thermal gradients arise.
FIG. 7 is a schematic representation of a top view an example of a floating coupling that can be used in the pallets of FIGS. 1-6.
FIG. 8 is a schematic representation of a cross-sectional view the floating coupling of FIG. 7 taken along section AA.
FIG. 9 is a schematic representation of a cross-sectional view of another example of a floating coupling that can be used in the pallets of FIGS. 1-6.
FIG. 10 is a schematic representation of a top view an example of a fixed coupling that can be used in the pallets of FIGS. 1-6.
FIG. 11 is a schematic representation of a cross-sectional view the fixed coupling of FIG. 10 taken along section BB.
FIG. 12 is a schematic representation of a cross-sectional view of another example of a fixed coupling that can be used in the pallets of FIGS. 1-6.

Like reference symbols in the various drawings indicate like elements.

### DETAILED DESCRIPTION

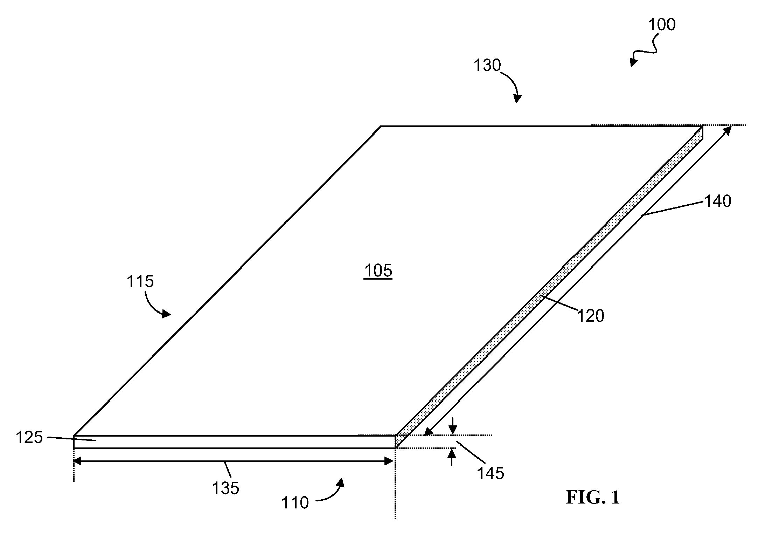

FIG. 1 is a schematic representation of a pallet 100. Pallet 100 is a portable platform for handling or storing substrates during processing, including processing systems where relatively large thermal gradients arise. Pallet 100 can be loaded to support a number of substrates simultaneously. A loaded pallet 100 can generally be handled or stored more easily than the individual substrates can be handled or stored. As described further below, pallet 100 can have any of a number of different features that are adapted for use in processing systems where relatively large thermal gradients arise.

Pallet 100 includes a top 105, a bottom 110, a front 115, a back 120, and a pair of sides 125, 130. Pallet 100 can span a distance 135 between front 115 and back 120. Pallet 100 can span a distance 140 between sides 125, 130. Pallet 100 can also span a thickness 145 between top 105 and bottom 110. Thickness 145 can be significantly shorter than distances 135, 140, giving pallet 100 a generally planar shape as shown. Substrates can be loaded onto and supported by pallet 100, e.g., on top 105, on bottom 110, between top 105 and bottom 110, or in combinations of such arrangements.

In some processing systems, pallet 100 is introduced into the processing system front-first, i.e., with front 115 leading and back 120 following. In some processing systems, contact is made with pallet 100 at sides 125, 130. For example, as described further below, sides 125, 130 can include one or more contact members that include surfaces contacted by handling and/or storage devices. Pallet 100 can be removed from a processing system either front-first or back-first.

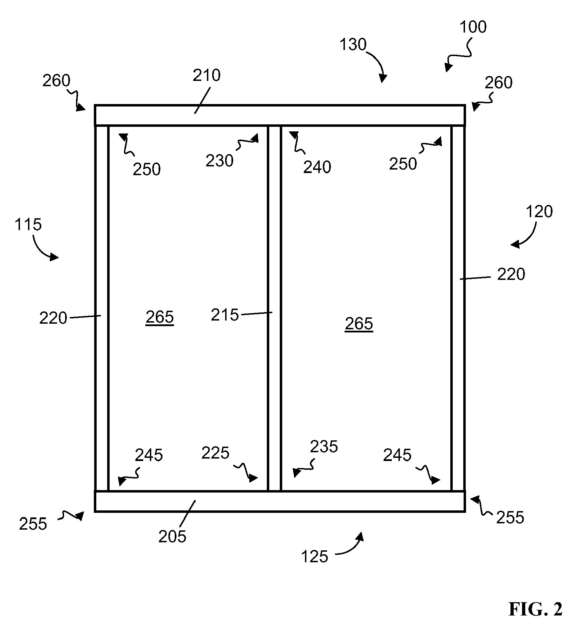

FIG. 2 is a schematic representation of an example pallet 100 that is adapted for use in processing systems where relatively large thermal gradients arise. The illustrated implementation of pallet 100 is particularly adapted so that substrates can be appropriately supported on pallet 100 despite relatively large thermal gradients existing, e.g., between front 115 and back 120.

Pallet 100 includes a pair of side contact members 205, 210, a fixed lateral member 215, and one or more floating lateral members 220. Side contact members 305, 310 are generally elongate mechanical elements that include one or more surfaces that are contacted by handling and/or storage devices. Side contact members 305, 310 are generally parallel with one another and longitudinally extend between front 115 and back 120. Side contact members 305, 310 can be made from, e.g., stainless steel. In the illustrated implementation, side contact members 305, 310 define the outer edges of pallet 100 at sides 125, 130.

Fixed lateral member 215 is generally elongate and spans between a pair of ends 225, 230. End 225 is fixedly coupled to contact member 205 at a coupling 235. End 230 is fixedly coupled to contact member 210 at a coupling 240. Ends 225, 230 can be coupled to side contact members 205, 210 with ends 225, 230 in direct physical contact with side contact members 205, 210 or via one or more intermediate members. In the illustrated implementation, fixed lateral member 215 is oriented generally perpendicularly to contact members 205, 210, although other orientations are possible. In the illustrated implementation, couplings 235, 240 are found near the middle of the length of contact members 205, 210, although other positions are possible. Fixed lateral member 215 can be made from, e.g., stainless steel.

Each floating lateral member 220 is a generally elongate and spans between a pair of ends 245, 250. Each end 245 is coupled to contact member 205 at a floating coupling 255. Each end 250 is coupled to contact member 210 at a floating coupling 260. Couplings 255, 260 are floating in that floating lateral member 220 can expand and contract longitudinally without concomitant deflection of contact members 205, 210. Each floating lateral member 220 is displaced from fixed lateral member 215 toward front 115 or back 120 to define a respective gap 265 therebetween that extends between side contact members 205, 210. Ends 245, 250 can be floatingly coupled to side contact members 205, 210 with ends 245, 250 in direct physical contact with side contact members 205, 210 or via one or more intermediate members. Floating lateral members 220 can be made from, e.g., stainless steel.

In the illustrated implementation, a first of floating lateral members 220 is positioned at front 115 and forms the front edge of pallet 100. A second of floating lateral members 220 is positioned at back 120 and forms the back edge of pallet 100. Other positioning of floating lateral members 220 is possible.

In use, pallet 100 can be introduced into a variety of different processing devices to transport loaded substrates into the processing devices. For example, in some instances, pallet 100 are introduced into sputtering or evaporation devices. The processing devices may be kept at temperatures that are sufficiently above the temperature of pallet 100 as it is introduced to induce a relatively large thermal gradient in pallet 100. For example, the sputtering or evaporation devices into which a roomtemperature pallet is introduced may be kept at temperatures in excess of 100°C. Nevertheless, pallet 100 can accommodate such relatively large thermal gradients with a single lateral member (i.e., fixed lateral member 215) being fixedly coupled to contact members 205, 210. In particular, different temperatures at front 115 and back 120 do not cause excessively different deflection of contact members 205, 210 at front 115 and back 120. Floating couplings 255, 260 accommodate longitudinal expansion and contraction of floating lateral member 220 without concomitant deflection of contact members 205, 210. The lateral positioning of contact members 205, 210 is instead set by a single fixed lateral member 215.

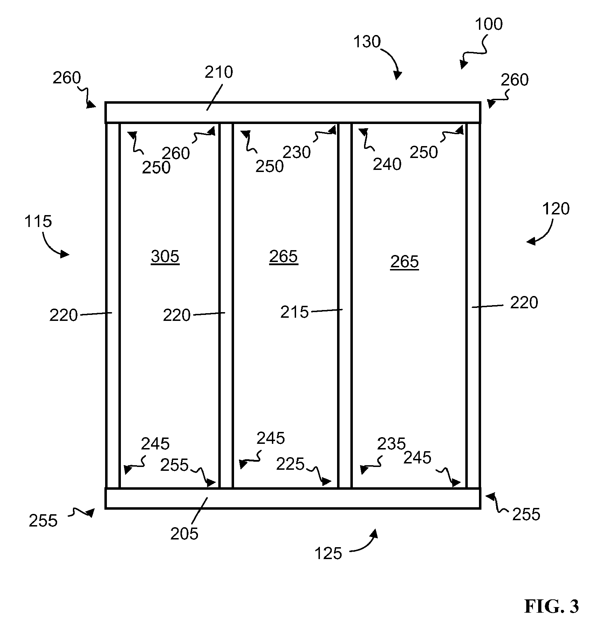

FIG. 3 is a schematic representation of an example pallet 100 that is adapted for use in processing systems where relatively large thermal gradients arise. The illustrated implementation of pallet 100 is particularly adapted so that substrates can be appropriately supported on pallet 100 despite relatively large thermal gradients existing, e.g., between front 115 and back 120.

In addition to side contact members 205, 210 and fixed lateral member 215, the illustrated implementation of pallet 100 includes a three floating lateral members 220. The first of floating lateral members 220 is positioned at front 115 and forms the front edge of pallet 100. The second of floating lateral members 220 is positioned at back 120 and forms the back edge of pallet 100. The third of floating lateral members 220 is positioned at an intermediate position between front 115 and back 120. The third of floating lateral members 220 is displaced from the first of floating lateral members 220 to define a gap 305 therebetween that extends between side contact members 205, 210.

Further, in the illustrated implementation, couplings 235, 240 between fixed lateral member 215 and contact members 205, 210 are displaced from the middle of the length of contact members 205, 210.

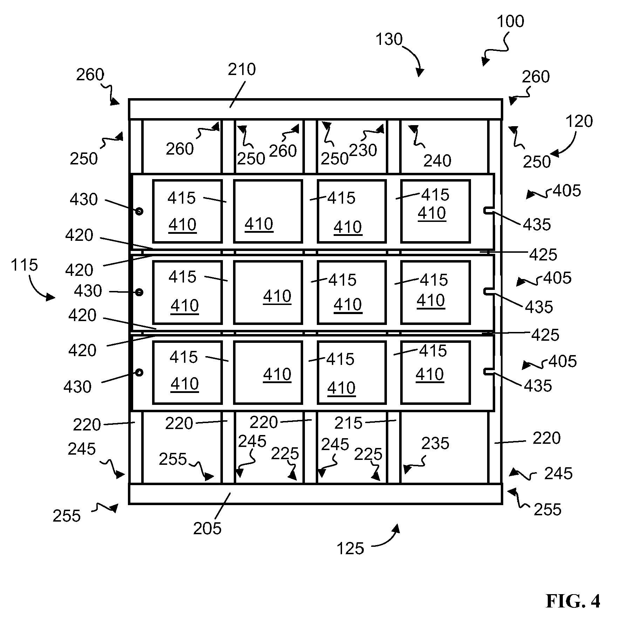

FIG. 4 is a schematic representation of an example pallet 100 that is adapted for use in processing systems where relatively large thermal gradients arise.

In addition to side contact members 205, 210, fixed lateral member 215, and floating lateral members 220, the illustrated implementation of pallet 100 also includes a collection of substrate mounting frames 405. Substrate mounting frames 405 provide one or contact surfaces for supporting substrates on pallet 100 and can be made, e.g., from stainless steel. In the illustrated implementation, substrate mounting frames 405 are generally elongate members that each define a collection of longitudinally-arranged openings 410 though which relevant portions of mounted substrates are exposed to processing conditions. For example, portions of the substrates may be exposed deposition of films from above (e.g., "sputter down" depositions) and deposition of films from below (e.g., "sputter up" depositions or evaporations).

The longitudinally arranged openings 410 are separated by portions 415. In the illustrated implementation, substrate mounting frames 405 are arranged to extend across the span between front 115 and back 120 and are supported by fixed and floating lateral members 215, 220 from below. In other implementations, substrate mounting frames 405 can have different shapes, extend over a portion of the span between front 115 and back 120, and/or can be arranged to extend across some portion of the span between side contact members 205, 210. In the illustrated implementation, portions 415 align with fixed lateral member 215 and floating lateral members 220 so that the tops and bottoms of mounted substrates are both exposed, e.g., for deposition from above and below.

In the illustrated implementation, substrate mounting frames 405 are aligned generally parallel with one another and have sides 420 are adjacent one another. In some implementations, a relatively small gap 425 can be defined between adjacent sides 420 of neighboring substrate mounting frames 405 to accommodate thermal expansion of substrate mounting frames 405 and ensure that deposited materials do not form fragile bridges between neighboring substrate mounting frames 405 that could potentially contaminate processing devices.

In some implementations, substrate mounting frames 405 are not only supported by fixed and floating lateral members 215, 220 and/or side contact members 205, 210 (in direct contact or via one or more intermediate members), but substrate mounting frames 405 can be coupled to fixed and floating lateral members 215, 220 and/or side contact members 205, 210. For example, substrate mounting frames 405 can be fixedly coupled to a first of the floating lateral members 220 (e.g., by a bolt or other fastener snugly received in a receptacle 430 in substrate mounting frame 405) and floatingly coupled to a second of the floating lateral members 220 (e.g., by a bolt or other fastener slidably received in a slotted receptacle 435 in substrate mounting frame 405). The coupling can be floating in that longitudinal expansion and contraction of substrate mounting frame 405 can be accommodated without deflection of floating lateral members 220.

In some implementations, substrate mounting frames 405 have features that are adapted for positioning and holding substrates at particular positions relative to portions of the processing devices. Examples of such positioning and holding features include lips, raised portions, or other elements. In some implementations, positioning and holding features are found on both sides of substrate mounting frames 405 so that substrate mounting frames 405 which have been preferentially contaminated by processing on one side can be de-coupled from the remainder of pallet 100, flipped over, and re-coupled with a less-contaminated side exposed for positioning and holding substrates.

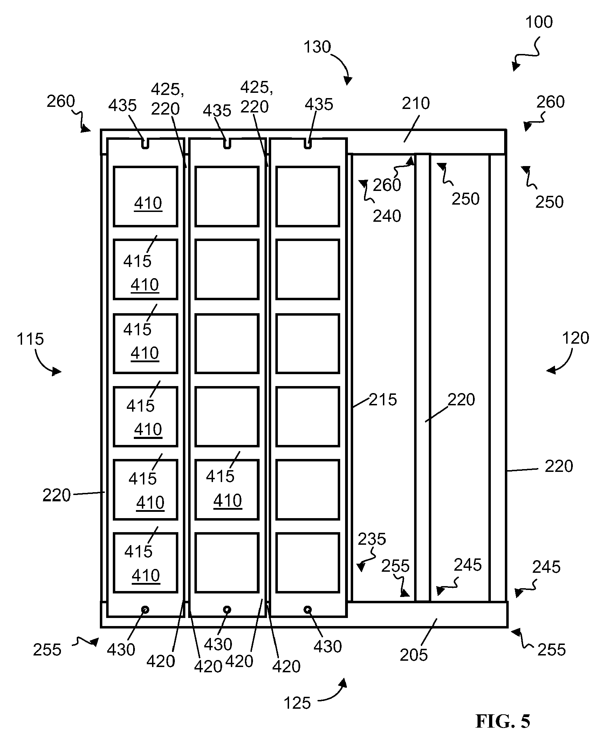

FIG. 5 is a schematic representation of an example pallet 100 that is adapted for use in processing systems where relatively large thermal gradients arise. Pallet 100 includes side contact members 205, 210, fixed lateral member 215, floating lateral members 220, and substrate mounting frames 405.

In the illustrated implementation, substrate mounting frames 405 are aligned generally parallel with one another disposed to extend across the span between side contact members 205, 210. Further, substrate mounting frames 405 are dimensioned and positioned so that sides 420 are above a fixed or floating lateral member 215, 220. In some implementations, substrate mounting frames 405 can be supported by these lateral members 215, 220.

In some implementations, substrate mounting frames 405 are not only supported by fixed and floating lateral members 215, 220 and/or side contact members 205, 210 (in direct contact or via one or more intermediate members), but substrate mounting frames 405 can be coupled to fixed and floating lateral members 215, 220 and/or side contact members 205, 210. For example, substrate mounting frames 405 can be fixedly coupled to side contact member 205 (e.g., by a bolt or other fastener snugly received in a receptacle 430 in substrate mounting frame 405) and floatingly coupled to side contact member 210 (e.g., by a bolt or other fastener slidably received in a slotted receptacle 435 in substrate mounting frame 405). The coupling can be floating in that longitudinal expansion and contraction of substrate mounting frame 405 can be accommodated without deflection side contact members 205 210.

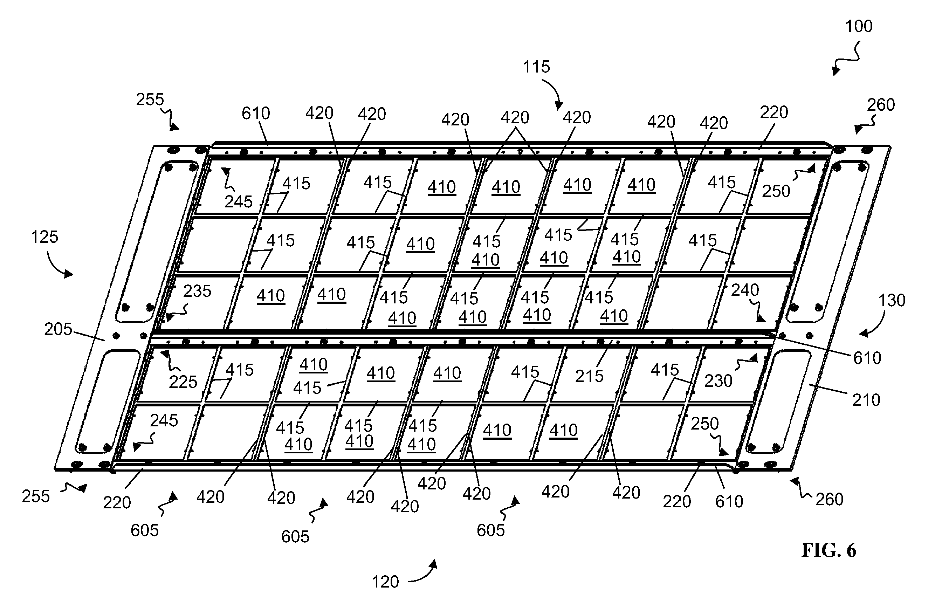

FIG. 6 is a schematic representation of an example pallet 100 that is adapted for use in processing systems where relatively large thermal gradients arise. Pallet 100 includes side contact members 205, 210, fixed lateral member 215, floating lateral members 220, and substrate mounting frames 405.

In the illustrated implementation, couplings 235, 240 between fixed lateral member 215 and contact members 205, 210 are displaced from the middle of the length of contact members 205, 210. Further, not all substrate mounting frames 405 are elongate. For example, certain 605 of the substrate mounting frames 405 define four openings 410 that are arranged both longitudinally and laterally to form generally square-shaped substrate mounting frames 405. Consequently, some portions 415 separating openings 410 are aligned generally parallel to fixed and floating lateral members 215, 220 whereas other portions 415 separating openings 410 are aligned generally parallel to side contact members 205, 210.

Further, in the implementation illustrated in FIG. 6, substrate mounting frames 405 do not extend across the entire span between front 115 and back 120. Instead, one half of the substrate mounting frames 405 extend between fixed lateral member 215 and a first of floating lateral members 220 disposed toward front 115 whereas the other half of the substrate mounting frames 405 extend between fixed lateral member 215 and a second of floating lateral members 220 disposed toward back 120.

In the illustrated implementation, fixed and floating lateral members 215, 220 each include a vertical rib 610. Rib 610 extends vertically from the generally planar structure of pallet 100 to stiffen fixed and floating lateral members 215, 220 against bending in the vertical direction.

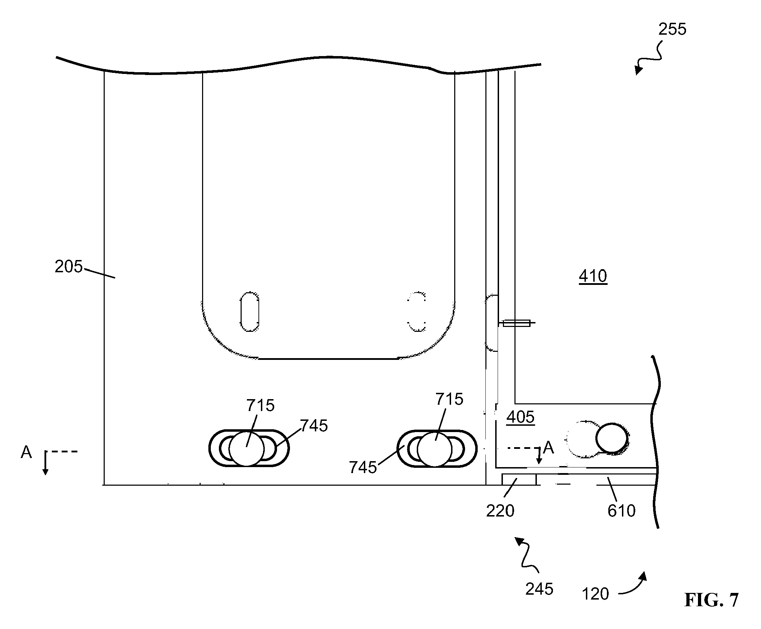

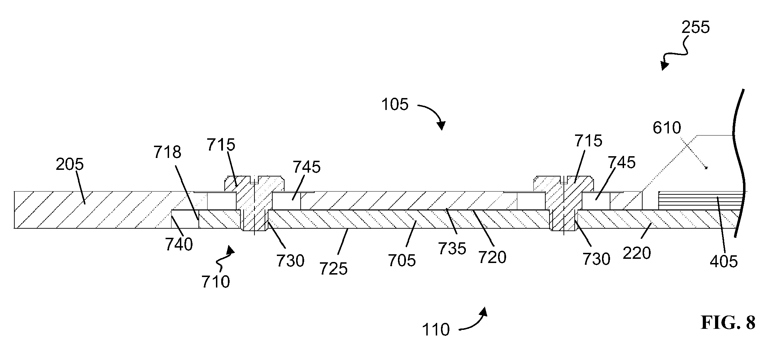

FIG. 7 is a schematic representation of a top view an example of floating coupling 255 between side contact member 205 and floating lateral member 220 at back 120 in pallet 100, e.g., as shown in FIGS. 1-6. FIG. 8 is a schematic representation of a cross-sectional view the same example of coupling 255 taken along section AA in FIG. 7. Other floating couplings 255, 260 can be made in a similar manner with appropriate changes in orientation and position.

The illustrated implementation of floating coupling 255 includes an extension 705 of floating lateral member 220, a depression 710 in side contact member 205, and a pair of fasteners 715. Extension 705 extends longitudinally outward from end 245 of floating lateral member 220 to an end 718. Extension 705 includes a top 720, a bottom 725, and defines a pair of fastener receptacles 730. Vertical rib 610 does not extend over extension 705.

Depression 710 in side contact member 205 is dimensioned to slidably receive extension 705. Depression 710 is defined by a top surface 735 and a side surface 740. A pair of slotted receptacles 745 are defined in side contact member 205 and pass from the top of side contact member 205 to depression 710. Slotted receptacles 745 are positioned to align with fastener receptacles 730 when pallet 100 is in the assembled state.

In the assembled state, top 720 of extension 705 is held in slidable contact with top surface 735 of depression 710 by fasteners 715. End 718 of extension 705 is not in contact with side surface 740 of depression 710 at room temperature. Fasteners 715 pass through slotted receptacles 745 and are fixed within fastener receptacles 730. Fasteners 715 can slide within slotted receptacles 745 and end 718 can move relative to side surface 740 to accommodate longitudinal thermal expansion of floating lateral member 220.

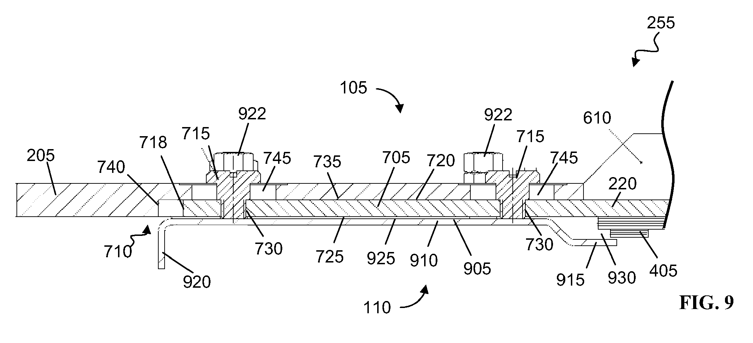

FIG. 9 is a schematic representation of a cross-sectional view of an example of floating coupling 255. Other couplings 255, 260 can be made in a similar manner with appropriate changes in orientation and position. The illustrated implementation of floating coupling 255 is adapted for a pallet 100 in which substrate mounting frames 405 are disposed at pallet bottom 110. For example, a pallet resembling pallet 100 of FIG. 6, but with substrate mounting frames 405 disposed at pallet bottom 110 can be formed. Further, the pallet includes a shielding member 905 that is itself disposed at pallet bottom 110 and shields pallet bottom 110 from, e.g., evaporation deposition from below.

Shielding member 905 includes a body 910, a lip 915, and a spacer 920. Body 910 has a top surface 925. In the assembled state, shielding member 905 is coupled to side contact member 205 by fasteners 922 that pass through receptacles in side contact member 205. Top surface 925, top surface 735, and side surface 740 together define depression 710 which as before receives extension 705. In some implementations, top surface 925 of body 910 can contact bottom 725 of extension 705, although this is not necessarily the case.

Lip 915 extends downwardly from body 910 so that top surface 925 defines a gap 930 with floating lateral member 220. Gap 930 is dimensioned to receive a portion of substrate mounting frame 405. The received portion of substrate mounting frame 405 is shielded by at least a portion of top surface 925. In the illustrated implementation, the portion of substrate mounting frame 405 received in gap 930 is smaller than gap 930. Thermal expansion and contraction of substrate mounting frame 405 can be accommodated by sliding movement within gap 930.

Spacer 920 also extends downwardly from body 910. Spacer 920 can extend further downward than lip 915 and can separate stacked pallets 100 so that substrates in substrate mounting frame 405 are not damaged.

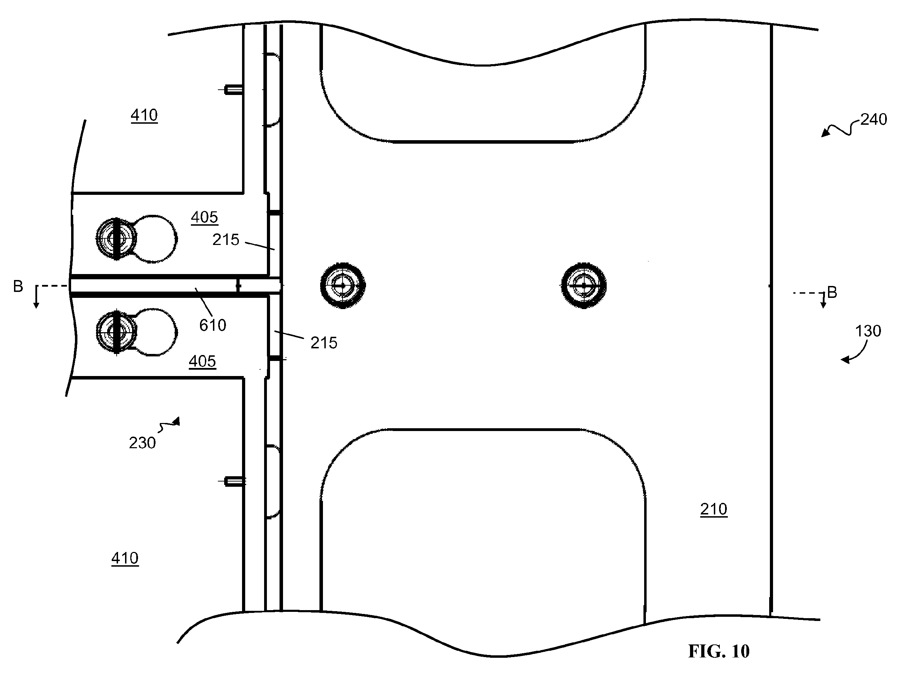

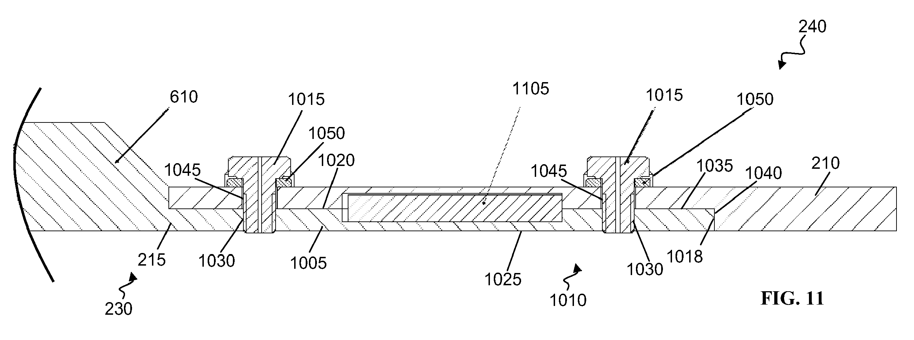

FIG. 10 is a schematic representation of a top view an example of fixed coupling 240 between side contact member 210 and fixed lateral member 215 at side 130 in pallet 100, e.g., as shown in FIGS. 1-6. FIG. 11 is a schematic representation of a cross-sectional view the same example of coupling 255 taken along section BB in FIG. 10. Coupling 235 can be made in a similar manner with appropriate changes in orientation and position.

The illustrated implementation of fixed coupling 240 includes an extension 1005 of fixed lateral member 215, a depression 1010 in side contact member 210, and a pair of fasteners 1015. Extension 1005 extends longitudinally outward from end 230 of fixed lateral member 215 to an end 1018. Extension 1005 includes a top 1020, a bottom 1025, and defines a pair of fastener receptacles 1030. Vertical rib 610 does not extend over extension 1005.

Depression 1010 in side contact member 210 is dimensioned to receive extension 1005. Depression 1010 is defined by a top surface 1035 and a side surface 1040. A pair of receptacles 1045 are defined in side contact member 210 and pass from the top of side contact member 210 to depression 1010. Receptacles 71045 are positioned to align with fastener receptacles 1030 when pallet 100 is in the assembled state.

In the assembled state, top 1020 of extension 1005 is fixedly held in contact with top surface 1035 of depression 1010 by fasteners 1015. End 1018 of extension 1005 can be in contact with side surface 1040 of depression 1010. Fasteners 1015 pass through receptacles 1045 and are fixed within fastener receptacles 1030. Washers 1050 can ensure that fasteners 1015 remain fixed.

The illustrated implementation of fixed coupling 240 also include a key 1105. Key 1105 can reduce or prevent relative motion between side contact member 210 and fixed lateral member 215.

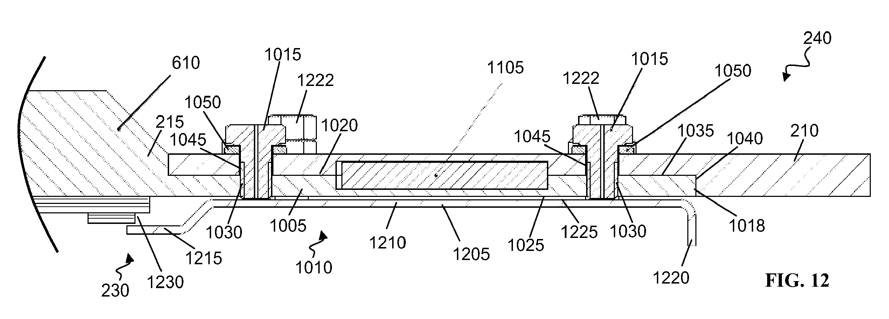

FIG. 12 is a schematic representation of a cross-sectional view of an example of fixed coupling 240. Coupling 235 can be made in a similar manner with appropriate changes in orientation and position. The illustrated implementation of fixed coupling 240 is adapted for a pallet 100 in which substrate mounting frames 405 are disposed at pallet bottom 110. In particular, the pallet includes a shielding member 1205 that is itself disposed at pallet bottom 110 and couples substrate mounting frames 405 to pallet 100.

Shielding member 1205 includes a body 1210, a lip 1215, and a spacer 1220. Body 1210 has a top surface 1225. In the assembled state, shielding member 1205 is coupled to side contact member 210 by fasteners 1222 that pass through receptacles in side contact member 210. Top surface 1225, top surface 1035, and side surface 1040 together define depression 1010 which as before receives extension 1005. In some implementations, top surface 1225 of body 1210 can contact bottom 1025 of extension 1005, although this is not necessarily the case.

Lip 1215 extends downwardly from body 1210 so that top surface 1225 defines a gap 1230 with fixed lateral member 215. Gap 1230 is dimensioned to receive a portion of substrate mounting frame 405. In the illustrated implementation, the portion of substrate mounting frame 405 received in gap 1230 is smaller than gap 1230. Thermal expansion and contraction of substrate mounting frame 405 can be accommodated by sliding movement within gap 1230.

Spacer 1220 also extends downwardly from body 1210. Spacer 1220 can extend further downward than lip 1215 and can separate stacked pallets 100 so that substrates in substrate mounting frame 405 are not damaged.

The illustrated implementation of fixed coupling 240 also include key 1105. Key 1105 can reduce or prevent relative motion between side contact member 210 and fixed lateral member 215.

A number of implementations have been described. Nevertheless, it will be understood that various modifications may be made. Accordingly, other implementations are within the scope of the following claims.

## Claims

1. A device comprising:
a generally planar substrate pallet (100) comprising:
a pair of elongate members (205, 210);
a fixed elongate lateral cross member (215) fixedly coupled to each of the elongate members (205, 210); and
an elongate floating lateral cross member (220) floatingly coupled to the elongate members (205, 210), the floating lateral cross member (220) displaced from the fixedly coupled lateral cross member (215) to define a gap (265) therebetween.

2. The device of claim 1, wherein the elongate members (215) each include one or more contact surfaces to be contacted by a handling or storage device.

3. The device according to any preceding claim, wherein the elongate members (215) are generally parallel and each define a side (125, 130) of the substrate pallet (100).

4. The device according to any preceding claim, wherein the pallet further comprises a substrate mounting frame (405, 605) dimensioned to span the gap (265) between the fixed lateral cross member (215) and the floating lateral cross member (220).

5. The device of claim 4, wherein the pallet further comprises a second substrate mounting frame (405, 605) dimensioned to span the gap (265) between the fixed lateral cross member (215) and the floating lateral cross member (220).

6. The device of claim 5, wherein a first coupling between the substrate mounting frame (405, 605) and the substrate pallet (100) and a second coupling between the second substrate mounting frame (405, 605) and the substrate pallet (100) position the substrate mounting frame (405, 605) and the second substrate mounting frame (405, 605) adjacent one another but with a gap (425) therebetween.

7. The device of claim 4, wherein the substrate mounting frame (405, 605) defines three or more openings (410) dimensioned to expose tops and bottoms of mounted wafer substrates to processing conditions.

8. The device of any of claims 1 to 3, wherein the pallet further comprises a substrate mounting frame (405) dimensioned to span between the elongate members (205,210).

9. The device according to any preceding claim, wherein the fixed lateral cross member (215) is fixedly coupled in a vicinity of the middle of the length of each of the elongate members (205, 210).

10. The device according to any preceding claim, wherein the elongate members (205, 210) and the fixed lateral cross member (215) are all 80 cm or more in length.

11. The device according to any preceding claim, wherein the pallet further comprises:
a second elongate floating lateral cross member (220) floatingly coupled to the elongate members (205, 210), the second floating lateral cross member (220) displaced from the fixedly coupled lateral cross member (215) to define a second gap (265) therebetween.
wherein the fixed lateral cross member (215) is positioned between the floating lateral cross member (220) and the second floating lateral cross member (220).

12. A method comprising:
loading substrates onto a pallet (100) comprising a first and second elongate members (205, 210) coupled together by a lateral cross member (215), the lateral cross member (215) fixedly coupled to the first elongate member (205) and fixedly coupled to the second elongate member (210);
transporting the pallet (100) and substrates loaded thereon into sputtering deposition device; and
sputtering a metal film onto the substrates in the sputtering deposition device.

13. The method of claim 12, wherein transporting the pallet (100) and substrates comprises contacting the elongate members (205, 210) with a transport device.

14. The method of claim 12 or 13, wherein loading substrates onto the pallet (100) comprises loading the substrates onto a substrate mounting frame (405, 605) having a first side coupled to at least one of the first elongate member (205), the second elongate member (210), or the fixedly coupled lateral cross member (215).

15. The method of claim 14, further comprising:
decoupling the first side of the substrate mounting frame from the at least one of the first elongate member (205), the second elongate member (210), or the fixedly coupled lateral cross member (215);
coupling a second side of the substrate mounting frame (405, 605) to the at least one of the first elongate member (205), the second elongate member (210), or the fixedly coupled lateral cross member (215).
